# EUROPÄISCHE PATENTSCHRIFT

(11) **EP 1 059 732 B1**
(45) Veröffentlichungstag und Bekanntmachung des Hinweises auf die Patenterteilung: **29.06.2005**
(21) Anmeldenummer: 00104007.0
(22) Anmeldetag: 25.02.2000
(51) Int. Cl.: H04B 1/18, H01Q 23/00, H03J 3/00, H03F 3/191

(54) **Abstimmbarer AM/FM-Antennenverstärker**
Tuneable antenna preamplifier
Préamplificateur accordable d'antenne

(30) Priorität: 07.06.1999 DE 19925869; 23.07.1999 DE 19934744
(43) Veröffentlichungstag der Anmeldung: 13.12.2000
(73) Patentinhaber: Microtune GmbH & Co KG, 85055 Ingolstadt (DE)
(72) Erfinder: Koch, Barry, 85053 Ingolstadt (DE)
(74) Vertreter: Bohnenberger, Johannes, Dr.

(56) Entgegenhaltungen:
- EP-A- 0 367 555
- EP-A- 0 637 093
- US-A- 3 965 426
- US-A- 5 428 830

## Beschreibung

Die vorliegende Erfindung bezieht sich auf ein aktives Schaltungsmodul mit einer abstimmbaren frequenzselektiven Eingangsstufe für Signale im FM-Band, und insbesondere auf einen FM-Pufferverstärker, der insbesondere für den Einsatz in Kraftfahrzeugen ausgelegt ist und frequenzselektive Schaltungen aufweist, wobei die Möglichkeiten zur Abstimmung vollständig im Inneren des Moduls realisiert sind.

Vom Gesichtspunkt der Leistungsfähigkeit aus ist die für den FM-Empfang in Fahrzeugen optimale Antenne der übliche feststehende Stab. Dies gilt insbesondere für die Fälle, in denen die Antenne auf der vorderen Stoßstange des Autos montiert ist, wobei zum Empfangsteil bzw. Tuner ein kurzes Stück Koax-Kabel führt. Unter diesen Bedingungen kann mit einer Kabelanpassung der Eingangsimpedanz des Empfängers gearbeitet werden, da die kapazitive Last am AM-Teil vom Koax-Kabel her so klein wie möglich wird. Durch die Verwendung eines solchen Kabels werden auch stehende Wellen zwischen der Antenne und dem Empfangsteil auf ein Mindestmaß reduziert. Das Richtdiagramm einer auf einer Metall-Stoßstange befestigten Stabantenne mit guter koaxialer Masseverbindung ist innerhalb des FM-Bandes überwiegend rundstrahlend.

Feststehende Stabantennen weisen jedoch eine Reihe von Nachteilen für den Verbraucher auf, wozu Windgeräusch, Aussehen und Empfindlichkeit gegenüber Vandalismus gehören.

In den Vereinigten Staaten hat man sich bei Kraftfahrzeugen der gehobeneren Klasse diesen Nachteilen insoweit gewidmet, als elektrisch einfahrbare Antennenstäbe verwendet werden, die eingefahren werden, wenn sie nicht gebraucht werden. Solche elektrisch betriebenen Stäbe bringen jedoch ein sehr großes Problem bei der Gewährleistung mit sich. Außerdem befinden sich elektrisch betriebene Stäbe in der Regel hinten am Auto, so daß lange Koax-Kabelleitungen erforderlich sind. Um kapazitive Lasten am AM-Teil auf ein Mindestmaß zu verringern, arbeitet man mit Kabeln mit höherer Impedanz (typische Impedanz bis zu 125 Ohm). Dies führt wegen stehender Wellen auf dem Koax-Kabel zu einer meßbaren Qualitätseinbuße im FM-Band. Die Leistung elektrisch bewegter Antennenstäbe ist im allgemeinen schlechter als bei feststehenden Stäben, und im Lauf der Zeit geht die Leistungsfähigkeit schneller verloren.

Alle diese Faktoren eröffnen attraktive Aussichten für konforme Antennen. Dies ist keineswegs ein neuer Gedanke, da der Einsatz von Antennen, die in die Scheiben von Kraftfahrzeugen eingelassen sind, in der Industrie übliche Praxis ist. Diese sogenannten Scheibenantennen sollen die Mängel der Stabantennen beheben, doch bringen sie weitere Probleme und Einschränkungen mit sich.

Die FM-Polarisierungscharakteristik der Scheibenantennen weist häufig eine vorwiegende horizontale Komponente auf, was zu elliptischer oder sogar kreisförmiger Polarisierung führt. Alle diese Aspekte führen zur erhöhten Wahrscheinlichkeit der Kreuzpolarisierung beim einlaufenden Signal. Dieses Phänomen führt zu einer "Null" in Richtcharakteristik bzw. Empfangsmuster, wenn das ankommende Signal entgegengesetzt polarisiert ist, und ist beim Empfang leicht zu hören. Dieses Charakteristikum kann mit entsprechendem Aufbau gemessen und dokumentiert werden.

Wegen der von der Form der Glasscheibe aufgezwungenen Kompromisse in der Konstruktion und auch wegen der Auswirkungen der umgebenden Karosserie des Fahrzeugs ist die gesamte FM-Leistung, die über Glasantennen empfangen wird, im allgemeinen niedriger. Dies führt zu einer wahrnehmbaren Verminderung der Empfindlichkeit des FM-Radios. Wie bei allen Antennen-Problemen kann es sein, daß Mängel, die durch ScheibenAntennen hervorgerufen werden, häufig irrtümlich einer schlechten Leistung des Empfängers zugeordnet werden.

Beim Einbau im Rückfenster werden Scheibenantennen gegenüber einem Rauschen besonders empfindlich, das von der Heckscheibenheizung herrührt und sich beim AM-Empfang bemerkbar macht. Diversity-Systeme haben zu Scheibenantennen geführt, die in die Windschutzscheibe vorn im Wagen eingelassen sind; doch können dort elektrische Störungen sowohl für den AM- als auch den FM-Empfang problematisch werden, die insbesondere vom Armaturenbrett ausgehen (Schaltrauschen elektronischer Einheiten).

Die Möglichkeit zur Plazierung von Scheibenantennen in einem Auto sind natürlich begrenzt, und dieser Punkt wird noch stärker in den Fällen, in denen Diversity-Systeme vorgesehen sind, insofern zum Problem, als man mehrere Antennen erhält, die in ausreichendem Maß nicht korreliert sind.

Eine der größten Herausforderungen bei Scheibenantennen (und in gewissem Maße bei allen konformen Antennen ganz allgemein) besteht in dem Konstruktionsaufwand, der zur Entwicklung einer guten Antenne erforderlich ist. Ein Verfahrensweg muß darin bestehen, das gesamte Empfangsmuster für eine Antenne hinsichtlich aller möglichen Polarisierungen des Empfangssignals zu messen. Dies kann dadurch erreicht werden, daß sowohl die horizontalen als auch die vertikalen Anteile im Empfangsmuster und die zwischen ihnen bestehenden Phasenbeziehungen gemessen werden. Wegen der Dualität der Antennen läßt sich die Empfangsantenne dadurch charakterisieren, daß sie stattdessen als Sendeantenne verwendet wird, und dann lassen sich die horizontalen und vertikalen Komponenten im Antennenmuster für alle Einfallswinkel messen. Wegen der Komplexität von Scheibenantennen muß ein großer Teil dieser Arbeit experimentell vorgenommen werden. Diese Arbeit muß natürlich auch separat für alle unterschiedlichen Automarken und -modelle vorgenommen werden.

Während sich Scheibenantennen vielleicht am leichtesten realisieren lassen, sind sie natürlich nicht die einzigen konformen Antennen, die sich in einem Kraftfahrzeug einbauen lassen. Der vielleicht am meisten versprechende Antennentyp ist die Schlitzantenne, die ähnliche Leistungsmerkmale wie eine feststehende Stabantenne aufweist. Allerdings müssen für die Realisierung von Schlitzantennen in einem Kraftfahrzeug viele Herausforderungen gemeistert werden. Die erste besteht in der Frage, wie diese Konstruktion realisierbar ist. Die einfachste Lösung bieten Kraftfahrzeuge, die nichtleitende Karosserieplatten (z.B. aus Glasfasermaterial usw.) aufweisen, wodurch Schlitzantennen in Form eines Metallfilms unter dem Karosserieblech eingelassen werden können. Ein weiterer Nachteil der Schlitzantennen ist deren Größe, die für eine optimale Leistung im FM-Band erforderlich ist.

Es gibt noch weitere mögliche konforme Antennen, zu denen auch isolierte Stabantennen im Karosserieblech und (in Dachstützen) verborgene Stabantennen gehören. Die meisten bringen eine Fülle technischer und konstruktionstechnischer Anforderungen bei mäßiger bis schlechter Leistung mit sich. Die zunehmende Verwendung konformer Antennen ganz allgemein und von Scheibenantennen im besonderen hat zur vorwiegenden Verwendung sogenannter Signal-Booster geführt. In ihrer allgemeinen Form handelt es sich hierbei um einfache Breitbandverstärker und/oder Puffer für AM- und FM-Signale. Für einen Schutz vor starken Signalen kann zusätzlich eine breitbandige Regelung des Verstärkungsfaktors vorgesehen sein, doch stellt dann ein "blocking" infolge starker benachbarter Kanäle ein potentielles Problem dar.

Der bessere Ansatz bestünde natürlich darin, das eigentliche Empfangsteil bzw. den Tuner am Antennenfuß anzuordnen. Dies bringt allerdings eine Reihe technischer Probleme mit sich, die noch nicht gelöst wurden. Es sind allerdings Zwischenschritte möglich, bei denen der Puffer eine gewisse Intelligenz erhält, beispielsweise eine beschränkte Fähigkeit zur Abstimmung. Hier stellt sich die Aufgabe, dieses Konzept in kostengünstiger Weise zu realisieren.

Die EP-A-0 637 093 offenbart ein Schaltungsmodul nach dem Oberbegriff von Anspruch 1.

Der Erfindung liegt die Aufgabe zugrunde, eine leistungsfähige und kostengünstige AM/FM-Empfangsanordnung anzugeben.

Erfindungsgemäß wird zur Lösung der genannten Aufgabe nun ein aktives Schaltungsmodul gemäß Anspruch 1 vorgesehen.

Diese Schaltung verstärkt und/oder puffert somit sowohl AMals auch FM-Signale, die von einer oder mehreren Antennen eingehen. Dabei sorgt das FM-Teil der Schaltung für eine Anpassung an die Antennen-Speiseimpedanz am Eingang. Da eine aktive Verstärkung des FM-Signals in der Schaltung erfolgt, ist als Schutz vor starken Signalen eine einbezogene AGC-Regelschaltung vorgesehen, wodurch der Dynamikbereich der Schaltung erweitert wird. Im Unterschied zu derartigen Schaltungen nach dem Stand der Technik ist bei dieser Schaltung für eine abgestimmte Selektivität für das FM-Signal gesorgt, wobei die Steuerung des Abstimmkreises im Inneren der aktiven Schaltung und getrennt vom Empfängersystem erfolgt. Des weiteren sieht die Erfindung auch eine aktive Schaltung für den AM-Anteil des Signals vor, wodurch für eine Impedanz-Pufferung zwischen der Antenne und der kapazitiven Last der anschließenden Verkabelung gesorgt ist.

Für die Selektivität im FM-Teil der Schaltung sorgen abstimmbare Bandpaßfilter nach dem Stand der Technik. Die Abstimmung dieser Filter erfolgt durch eine intern erzeugte Abstimmspannung, die für eine korrekte Einstellung der Filtermittenfrequenz auf die gewünschte Abstimmfrequenz sorgt. Im Unterschied zum Stand der Technik bei entfernt installiertem HF-Verstärker weist die Erfindung eine Oszillatorschaltung mit einem Abstimmbereich auf, der das gesamte in Frage kommende FM-Band abdeckt, wobei die Abstimmung dieses Oszillators über eine typische AGC-Regelschleife zur automatischen Regelung des Verstärkungsfaktors nach dem Stand der Technik erreicht wird. Das Oszillatorsignal ist vom Eingangssignal und der Selektivitätsschaltung getrennt, da der einzige Zweck des Oszillatorsignals darin besteht, ein Eingangssignal für den Phasenregelkreis (PLL-Schaltung) in der Weise zu liefern, daß eine reproduzierbare Abstimmfrequenz für die abgestimmten Schaltungen vorliegt. Der Abgleich des abstimmbaren Filterteils erfolgt während der Herstellung gemäß dem Stand der Technik.

In einer Ausführungsform umfaßt die Erfindung eine aktive Zwei-Band-Schaltung, welche die Signalwege für die AM- und FM-Frequenzen trennt. Dabei weist das FM-Teil neben anderen Teilen einen oder mehrere abstimmbare Filterblöcke, einen oder mehrere Verstärker bzw. Puffer mit unveränderlicher oder veränderlicher Verstärkung als aktive Bauelemente und ein oder mehrere Dämpfungsteile auf. Außerdem werden die abstimmbaren Filterblöcke über eine Spannung gesteuert, die von einer PLL-Schaltung erzeugt wird, welche neben anderen Elementen einen integrierten PLL-Baustein, eine Referenzfrequenz-Quelle, wie einen Kristallresonator, einen spannungsgesteuerten Oszillator, der zur Abstimmung über das gesamte in Frage kommende Frequenzband geeignet ist, und entsprechende Schleifenfilter für die Abstimmspannung aufweist. Außerdem sind Vorkehrungen für die Ansteuerung des PLL-Elements in Form einer entsprechenden Busleitung getroffen.

Im AM-Teil sind neben anderen Bauteilen ein Vorfilter und ein Impedanzpuffer bzw. -verstärker vorgesehen.

Daraus wird deutlich, daß ein großer Teil der Funktionalität im FM-Block, insbesondere die PLL- und Oszillatorschaltungen, sich problemlos kostengünstig in einem integrierten Baustein realisieren läßt.

Ein Vorteil der vorliegenden Erfindung besteht darin, daß im Unterschied zu bekannten entfernt installierten HF-Verstärkern oder Puffern die Abstimmbarkeit in einer Weise realisiert ist, daß vom Empfangsteil kein Regel- oder Steuersignal erforderlich ist, und damit ist tatsächlich eine vom Aufbau des Empfangsteils unabhängige Arbeitsweise der Erfindung realisiert.

Ein weiterer Vorteil der vorliegenden Erfindung besteht darin, daß die Einheit weniger empfindlich gegenüber starken Signalen außerhalb der Bandbreite der abstimmbaren Filter ist, da die am Verstärker bzw. Puffer in der Einheit einfallende Signalbandbreite gegenüber dem von der Antenne bzw. den Antennen empfangbaren Eingangssignal schmal ist. Außerdem ist die Wahrscheinlichkeit, daß die AGC-Schaltung für die automatische Verstärkungsregelung (AGC) von einem starken Signal außerhalb der Bandbreite aktiviert wird, verringert, da die Erfassungsschaltung für die automatische Verstärkungsregelung einem oder mehreren Abschnitten der abstimmbaren Filter folgt.

Darüber hinaus liegt ein weiterer Vorteil der Erfindung darin, daß das Ausgangssignal der Einheit und damit das Eingangssignal für das Systemempfangsteil im Vergleich zu dem von der Antenne bzw. den Antennen empfangbaren Eingangssignal schmalbandig ist. Diese Vorselektion kann unter anderem die Nachbarkanal-Performance und das Spiegelselektionsverhalten verbessern.

Die vorliegende Erfindung bietet außerdem noch den Vorteil, daß die Änderungen mit der Temperatur, Alterungsverhalten und weitere negative Auswirkungen nicht nur gut bekannt sind, sondern auch den Änderungen beim Empfangsteil selbst eng folgen, da der PLL-Abstimmkreis, der in dem entfernt installierten Modul realisiert ist, dem PLL-Abstimmkreis in derzeit bekannten Empfangsteilen hinsichtlich seiner Konstruktion und seiner Art sehr ähnlich ist.
- Fig. 1: zeigt einen ersten erfindungsgemäßen abstimmbaren entfernt installierten AM/FM-Puffer im Blockschaltbild;
- Fig. 2: ist das Blockschaltbild eines weiteren erfindungsgemäßen abstimmbaren entfernt installierten AM/FM-Puffers und
- Fig. 3: stellt ebenfalls das Blockschaltbild eines erfindungsgemäßen abstimmbaren entfernt installierten AM/FM-Puffers dar.

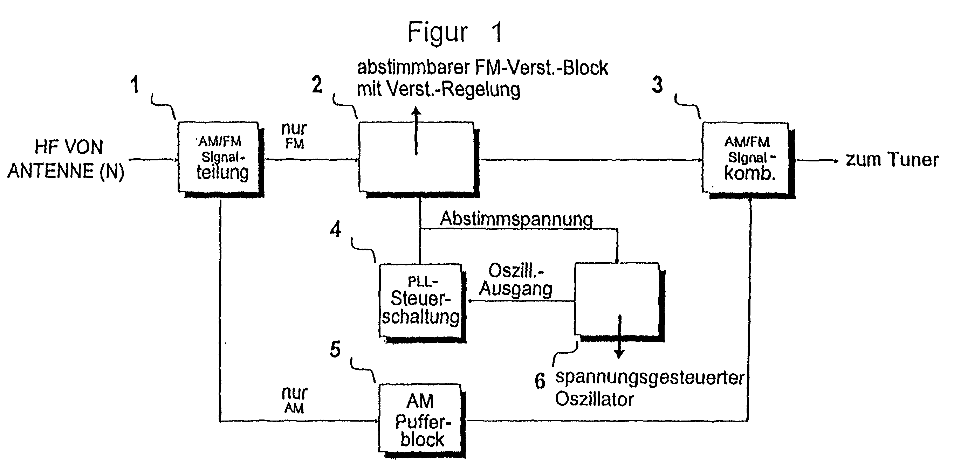

Fig. 1 zeigt ein Ausführungsbeispiel des erfindungsgemäßen abstimmbaren, entfernt installierten Verstärkers. Bei diesem Ausführungsbeispiel werden die von der Antenne bzw. den Antennen, die an der Einheit angeschlossen sind, empfangenen Signale von dem Baustein 1 in getrennte AM- und FM-Frequenzbänder aufgeteilt. Das FM-Ausgangssignal aus dem Signalteiler 1 wird von der Schaltung 2 hinsichtlich der Bandbreite begrenzt und im Pegel geregelt, wobei die Bandbegrenzung durch abstimmbare Filter vorgenommen wird, die über eine Abstimmspannung gesteuert werden, die von der PLLSteuerschaltung 4 zugeführt wird. Diese Abstimmspannung steuert auch den spannungsgesteuerten Oszillator 6, dessen Ausgangs-Frequenzbereich mindestens genauso breit wie das interessierende FM-Band ist. Der HF-Ausgang des Oszillators wird von der PLL-Steuerschaltung 4 nur zu Abstimmzwecken verwendet. Die PLL-Steuerschaltung hält ein frequenz-geteiltes Ausgangssignal des Oszillators 6 phasenstarr auf einer Referenzfrequenz, die von der Schaltung im Schaltungsblock 4 kommt. Der AM-Anteil des Signals aus dem Signalteiler 1 wird einem Puffer- bzw. Verstärkerblock 5 mit hoher Impedanz und niedrigem kapazitiven Widerstand zugeführt, wobei der Ausgang dieses Blocks 5 eine Ansteuerimpedanz aufweist, die ausreichend niedrig ist, um eine Last mit hohem kapazitiven Widerstand ohne übermäßig starke Signaldämpfung anzusteuern. Die Ausgänge der AM- und FM-Teile werden im Block 3 wieder zusammengeführt und miteinander verknüpft, dessen Ausgang als standardmäßiger Eingang für das anschließende Empfangsteil vorgesehen ist.

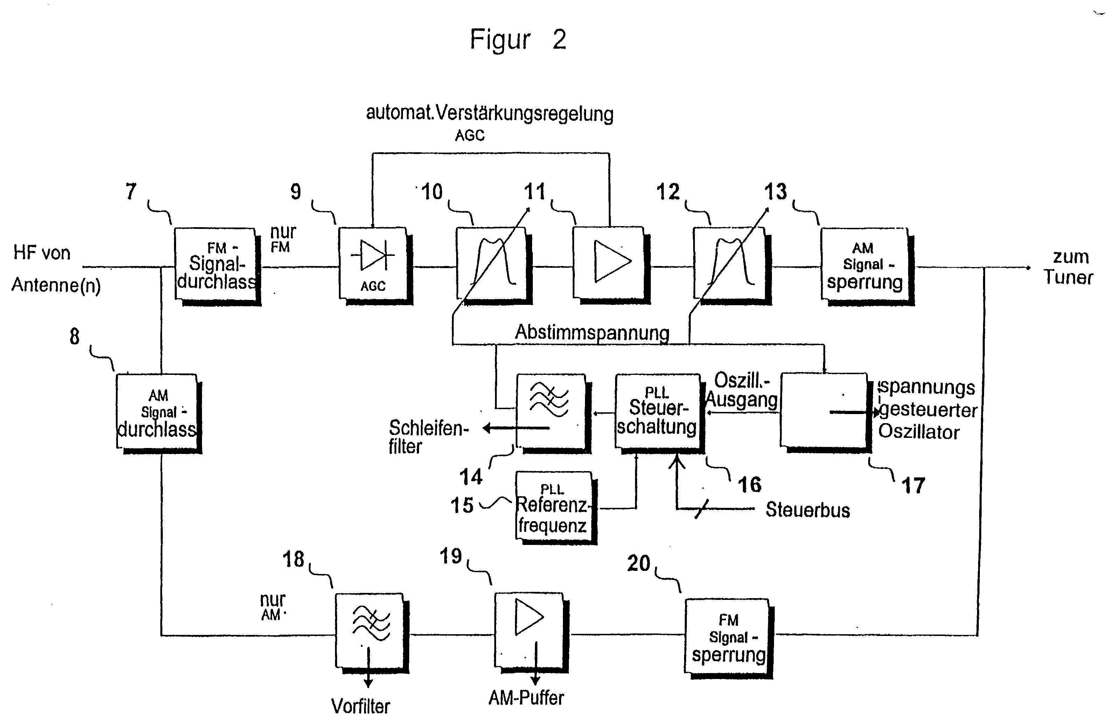

Figur 2 zeigt ein weiteres Ausführungsbeispiel des erfindungsgemäßen abstimmbaren, entfernt installierten Verstärkers. Bei diesem Ausführungsbeispiel wird der FM-Anteil des von der Antenne bzw. den Antennen empfangenen Eingangssignals vom Block 7 dem Dämpfungsblock 9 mit variabler Dämpfung zugeführt. Im Anschluß an die Dämpfung wird das Signal dem abstimmbaren Filter 10 zugeführt, dessen Ausgangssignal dem Verstärkerteil 11 zugeführt wird. Die Steuerspannung für den Dämpfungsblock 9 wird hinter dem abstimmbaren Filter 10 erzeugt. Hinter dem Verstärkerblock 11 wird das Signal wieder von einem abstimmbaren Filter 12 in seiner Bandbreite begrenzt. Das Ausgangssignal des Filters 12 durchläuft die AM-Signal-Sperrschaltung 13, ehe es mit dem Ausgangssignal aus dem AM-Teil wieder verknüpft wird. Die Abstimmspannung für die abstimmbaren Filter 10 und 12 liefert die PLL-Schleifenschaltung, die aus dem Schleifenfilter 14, der Referenzfrequenzquelle 15, dem Phasenregelkreis 16 und dem Oszillator 17 besteht. Die PLL-Steuerschaltung 16 skaliert die Frequenz der Eingangssignale vom Oszillator 17 und der Referenzquelle 15 auf eine gemeinsame Frequenz und vergleicht die Phasen der beiden Signale. Das Ausgangssignal aus dem PLL-Baustein 16 wird vom Schleifenfilter 14 gefiltert und dann derart an den Oszillator 17 angelegt, daß die Phasendifferenz zwischen den Vergleichsfrequenzen innerhalb der PLL-Schaltung auf ein Mindestmaß reduziert wird. Das Ausgangssignal des Oszillators 17 wird deshalb nur für den Frequenzvergleich innerhalb der PLL-Schaltung 16 verwendet, so daß eine reproduzierbare Abstimmspannung vorliegt, die zum Abstimmen der Filter 10 und 12 verwendet werden kann. Der AM-Anteil des Eingangssignals wird vom Block 8 zum Vorfilter 18 und anschließend zum AM-Puffer 19 geleitet. Das Ausgangssignal des Puffers 19 wird über ein Tiefpaßfilter zur Verknüpfung mit dem Ausgangssignal aus dem FM-Teil geleitet.

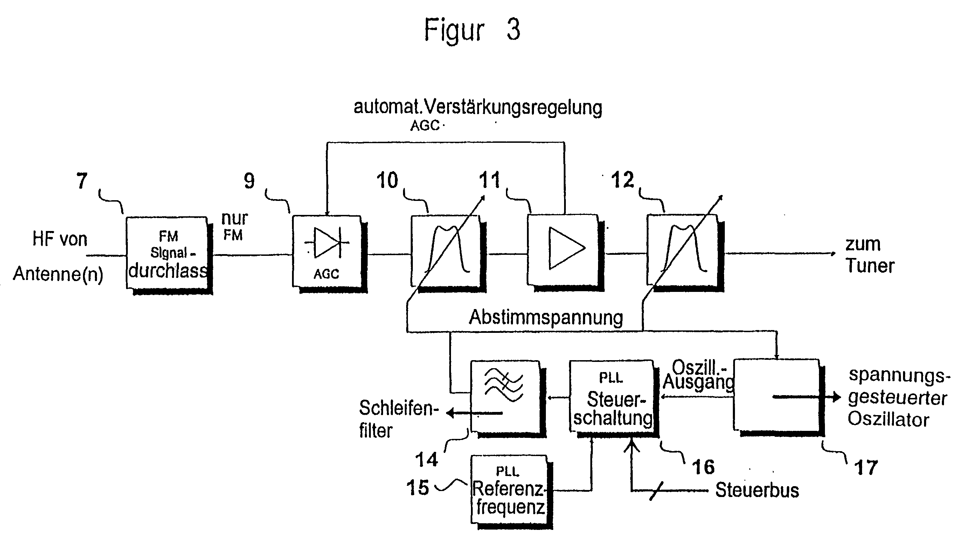

Figur 3 zeigt ein weiteres Ausführungsbeispiel des erfindungsgemäßen abstimmbaren, entfernt installierten Verstärkers. Bei diesem Ausführungsbeispiel ist nur der FM-Teil der Schaltung realisiert. Die Funktionsweise des FM-Teils ist identisch mit der Arbeitsweise des in Figur 2 dargestellten Falls. Das Ausführungsbeispiel der Erfindung hängt weder von der Verfahrensweise bei der Realisierung noch davon ab, ob ein AM-Signalteil vorhanden ist.

### Bezugszeichenliste

- 1: AM/FM-Signalteiler
- 2: FM-Verstärkerblock
- 3: AM/FM-Signalkombinierer
- 4: PLL-Steuerschaltung
- 5: AM-Puffer- bzw. Verstärkerblock
- 6; 17: Spannungsgesteuerter Oszillator
- 7: FM-Signaldurchlaß
- 8: AM-Signaldurchlaß
- 9: Dämpfungsblock
- 10, 12: abstimmbarer Filter
- 11: Verstärker
- 13: AM-Signal-Sperrschaltung
- 14: Schleifenfilter
- 15: Referenzfrequenzquelle
- 16: Phasenregelkreis (PLL-Steuerschaltung)
- 18: Vorfilter
- 19: AM-Puffer
- 20: FM-Signal-Sperrschaltung

## Patentansprüche

1. Aktives Schaltungsmodul mit einer abstimmbaren frequenzselektiven Eingangsstufe (2; 9 bis 12) für Signale im FM-Band, das in räumlich entfernter Konfiguration von einem Standard-FM-Empfangsteil betriebsfähig ist,
**dadurch gekennzeichnet,**
**daß** die Steuereinrichtung (4, 6; 14 bis 17) für das abstimmbare Filter von einer Oszillatorschaltung mit phasenstarrer Schleife gebildet ist, wobei die Erstreckung des Frequenzbereichs des Oszillators (6; 17) mindestens so breit ist wie das Eingangs-FM-Band und wobei die Oszillatorschaltung mit phasenstarrer Schleife vollständig intern in dem Modul gebildet ist, und daß die Steuerung der phasenstarren Schleife unabhängig von weiteren Abstimmstufen ist, die dem Modul optional nachgeschaltet sind.

2. Schaltungsmodul nach Anspruch 1,
**dadurch gekennzeichnet,**
**daß** zur Frequenzselektion mindestens ein spannungsgesteuertes abstimmbares Filter (2; 11, 12) vorgesehen ist und daß eine Steuereinrichtung (4, 6; 14 bis 17) für das abstimmbare Filter vollständig intern in dem Modul gebildet ist.

3. Schaltungsmodul nach Anspruch 1 oder 2,
**gekennzeichnet durch**
eine Eingangsanpassungsschaltung (9), welche die Ausgangsimpedanz mindestens einer Antenne in dem FM-Frequenzband an die Eingangsimpedanz des Moduls zur Maximierung des Rauschabstands des Moduls anpaßt.

4. Schaltungsmodul nach einem der vorhergehenden Ansprüche,
**dadurch gekennzeichnet,**
**daß** es des weiteren eine aktive Verstärkerschaltung (11) aufweist, mit welchem eine Verstärkung bei allen Frequenzen in dem FM-Frequenzband erzielbar ist, und daß der aktiven Verstärkerschaltung mindestens ein abstimmbares Filter (10) vorgeschaltet ist, wobei das Eingangssiqnalspektrum an der aktiven Verstärkerschaltung gegenüber der Bandbreite des Signals von der Antenne schmalbandig ist.

5. Schaltungsmodul nach einem der vorhergehenden Ansprüche,
**gekennzeichnet durch**
eine Automatik (9, 11) zum Steuern der Gesamtverstärkung des Signalpfads im FM-Band, wobei diese Automatik eine Steuerung der Verstärkung der aktiven Verstärkerschaltung bzw. der Dämpfung des Eingangssignals an der aktiven Verstärkerschaltung realisert, sofern eine aktive Verstärkerschaltung vergesehen ist.

6. Schaltungsmodul nach Anspruch 5,
**dadurch gekennzeichnet,**
**daß** die Automatik (9, 11) mit einer Regelschleife realisiert ist, welche ein dem Signalpegel am Ausgang der Automatik entsprechendes Steuersignal verwendet.

7. Schaltungsmodul nach einem der vorhergehenden Ansprüche,
**dadurch gekennzeichnet,**
**daß** es des weiteren ein separates Schaltungsteil (5; 8, 18 bis 20) aufweist, das für AM-Frequenzsignale vorgesehen ist.

8. Schaltungsmodul nach Anspruch 7,
**dadurch gekennzeichnet,**
**daß** eine Einrichtung (3) zum Kombinieren von Ausgangssignalen aus der AM-Schaltung und der FM-Schaltung in der Weise vorgesehen ist, daß beide Frequenzbänder aus dem Modul über eine einzige Leitung ausgebbar sind, welche zum Eingang eines Standard-Empfangsteils führt.

## Claims

1. An active circuit module with a tunable frequency-selective input stage (2;9 to 12) for signals in the FM band, which in a spatially remote configuration can be operated by a standard FM receiving part , **characterised in that** a control device (4,6;14 to 17) for the tunable filter is formed by an oscillator circuit with a phase-locked loop, wherein the extension of the frequency range of the oscillator (6;17) is at least as broad as the input FM band and wherein the oscillator circuit with phase-locked loop is formed completely internally in the module, and **in that** the control of the phase-locked loop is independent of further tuning stages which are optionally connected to the output side of the module.

2. A circuit module according to Claim 1, **characterised in that** at least one voltage-controlled tunable filter (2;11,12) is provided for frequency selection and **in that** a control device (4,6;14 to 17) for the tunable filter is formed completely internally in the module.

3. A circuit module according to Claim 1 or 2, **characterised by** an input-adapter circuit (9) which adapts the output impedance of at least one antenna in the FM frequency band to the input impedance of the module so as to maximise the signal-to-noise ratio of the module.

4. A circuit module according to any one of the preceding Claims, **characterised in that** it further has an active amplifier circuit (11) with which amplification can be achieved at all frequencies in the FM frequency band, and **in that** at least one tunable filter (10) is connected to the input side of the active amplifier circuit, wherein the input signal spectrum at the active amplifier circuit is narrow-band in relation to the band width of the signal from the antenna.

5. A circuit module according to any one of the preceding Claims, **characterised by** an automatic device (9,11) for controlling the total amplification of the signal path in the FM band, wherein this automatic device carries out control of the amplification of the active amplifier circuit or of the attenuation of the input signal at the active amplifier circuit, if an active amplifier circuit is provided.

6. A circuit module according to Claim 5, **characterised in that** the automatic device (9,11) is formed with a control loop which uses a control signal corresponding to the signal level at the output of the automatic device.

7. A circuit module according to any one of the preceding Claims, **characterised in that** it further has a separate circuit part (5;8,18 to 20) which is provided for AM frequency signals.

8. A circuit module according to Claim 7, **characterised in that** a device (3) is provided for combining output signals from the AM circuit and the FM circuit in such a way that both frequency bands can be output from the module via a single lead which leads to the input of a standard receiver part.

## Revendications

1. Module de circuit actif comportant un étage d'entrée (2 ; 9 à 12) accordable sélectif en fréquence pour des signaux dans la bande MF, qui peut être exploité par un récepteur MF standard en configuration éloignée spatialement,
**caractérisé en ce**
**que** le dispositif de commande (4, 6 ; 14 à 17) pour le filtre accordable est formé à partir d'un circuit oscillateur à boucle verrouillée en phase, l'étendue de la plage de fréquences de l'oscillateur (6 ; 17) étant au moins aussi large que la bande MF d'entrée et le circuit oscillateur à boucle verrouillée en phase étant formé de manière complètement interne dans le module, et que la commande de la boucle verrouillée en phase est indépendante d'autres étages d'accord qui sont montés en option en aval du module.

2. Module de circuit selon la revendication 1,
**caractérisé en ce**
**qu'**au moins un filtre (2 ; 11, 12) accordable commandé par tension est prévu pour la sélection de fréquence, et qu'un dispositif de commande (4, 6 ; 14 à 17) pour le filtre accordable est formé de manière complètement interne dans le module.

3. Module de circuit selon la revendication 1 ou 2,
**caractérisé par**
un circuit (9) d'adaptation d'entrée qui adapte l'impédance de sortie d'au moins une antenne dans la bande de fréquences MF à l'impédance d'entrée du module pour maximiser le rapport signal/bruit du module.

4. Module de circuit selon l'une des revendications précédentes,
**caractérisé en ce**
**qu'**il présente en outre un circuit amplificateur (11) actif avec lequel une amplification peut être obtenue sur toutes les fréquences dans la bande de fréquences MF, et qu'au moins un filtre (10) accordable est monté en amont du circuit amplificateur actif, le spectre des signaux d'entrée sur le circuit amplificateur actif étant à bande étroite par rapport à la largeur de bande du signal de l'antenne.

5. Module de circuit selon l'une des revendications précédentes,
**caractérisé par**
un automatisme (9, 11) pour commander l'amplification globale du chemin du signal dans la bande MF, cet automatisme réalisant une commande de l'amplification du circuit amplificateur actif ou de l'amortissement du signal d'entrée sur le circuit amplificateur actif dans la mesure où un circuit amplificateur actif est prévu.

6. Module de circuit selon la revendication 5,
**caractérisé en ce**
**que** l'automatisme (9, 11) est réalisé avec une boucle de régulation qui utilise un signal de commande correspondant au niveau de signal à la sortie de l'automatisme.

7. Module de circuit selon l'une des revendications précédentes,
**caractérisé en ce**
**qu'**il comporte en outre une partie de circuit (5 ; 8, 18 à 20) séparé qui est prévu pour des signaux de fréquence MA.

8. Module de circuit selon la revendication 7,
**caractérisé en ce**
**qu'**un dispositif (3) pour combiner des signaux de sortie hors du circuit MA et du circuit MF est prévu de façon que les deux bandes de fréquences puissent être délivrées hors du module par l'intermédiaire d'une seule ligne, qui conduit à l'entrée d'un récepteur standard.
